Europäisches Patentamt

European Patent Office

Office européen des brevets

(19)

(11) **EP 0 970 562 B1**

(12) **FASCICULE DE BREVET EUROPEEN**

(45) Date de publication et mention
de la délivrance du brevet:
**16.08.2001 Bulletin 2001/33**

(21) Numéro de dépôt: **98917243.2**

(22) Date de dépôt: **26.03.1998**

(51) Int Cl.$^7$: **H03H 17/02**

(86) Numéro de dépôt international:
**PCT/FR98/00615**

(87) Numéro de publication internationale:
**WO 98/44629 (08.10.1998 Gazette 1998/40)**

(54) **FILTRE NUMERIQUE POUR RETARDS FRACTIONNAIRES**

DIGITALFILTER FÜR FRAKTIONALE VERZÖGERUNGEN

FRACTIONAL DELAY DIGITAL FILTER

(84) Etats contractants désignés:
**CH DE ES GB IT LI NL**

(30) Priorité: **28.03.1997 FR 9703845**

(43) Date de publication de la demande:
**12.01.2000 Bulletin 2000/02**

(73) Titulaire: **FRANCE TELECOM**
**75015 Paris (FR)**

(72) Inventeur: **TAGER, Wolfgang**
**F-22300 Lannion (FR)**

(74) Mandataire: **Texier, Christian et al**
**Cabinet Régimbeau**
**20, rue de Chazelles**
**75847 Paris cedex 17 (FR)**

(56) Documents cités:
- **CETIN A E ET AL: "DIGITAL INTERPOLATION BEAMFORMING USING RECURSIVE FILTERS" JOURNAL OF THE ACOUSTICAL SOCIETY OF AMERICA, vol. 85, no. 1, 1 janvier 1989, pages 493-495, XP000096673**
- **SANGIL PARK: "REAL-TIME PITCH (FREQUENCY) SHIFTING TECHNIQUES" PROCEEDINGS OF THE INTERNATIONAL CONFERENCE ON CONSUMER ELECTRONICS (ICCE), ROSEMONT, JUNE 5 - 7, 1991, no. CONF. 10, 5 juin 1991, INSTITUTE OF ELECTRICAL AND ELECTRONICS ENGINEERS, pages 296-297, XP000289043**
- **T. I. LAAKSO ET AL.: "Splitting the Unit Delay, Tools for Fractional Delay Filter Design" IEEE SIGNAL PROCESSING MAGAZINE., vol. 13, no. 1, janvier 1996, NEW YORK US, pages 30-60, XP002050526 cité dans la demande**

**Description**

La présente invention concerne les dispositifs de traitement de signaux numériques qui réalisent des opérations de retard fractionnaire dans un contexte de traitement linéaire.

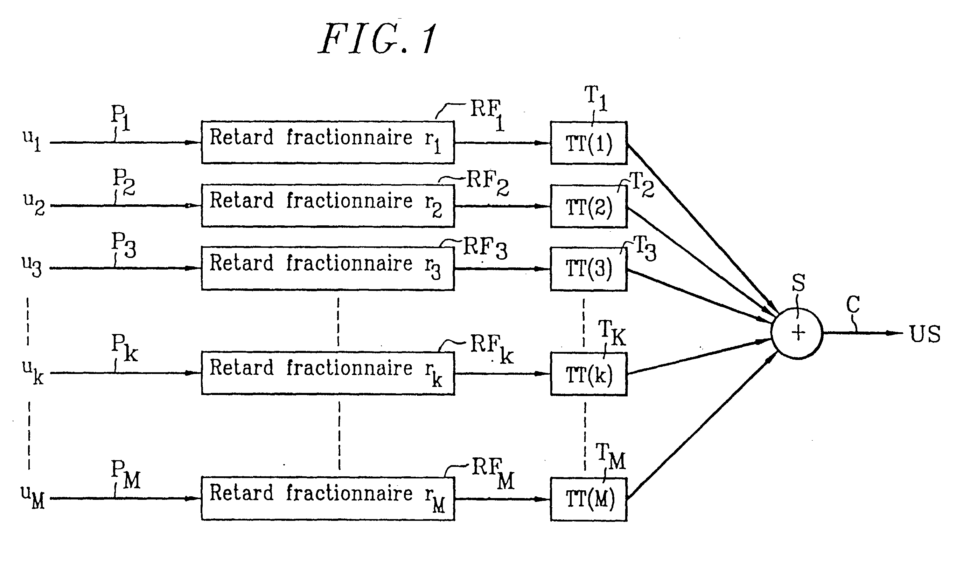

On connaît le principe de tels dispositifs. De manière classique et comme représenté à la figure 1, ces dispositifs comprennent en amont une rangée de filtres d'interpolation à Réponse Impulsionnelle Finie qui réalisent chacun une opération de retard fractionnaire spécifique à chaque signal d'entrée.

Un exemple d'un tel dispositif est divulgué dans Cotin & al. "Digital Interpolation Beamforming Using Recursive Filters", Journal of the Acoustical Society of America, Vol. 85, N°1, 01.01.1989, P. 493 - 495.

Chaque filtre d'interpolation à Réponse Impulsionnelle Finie est une approximation d'un filtre de retard fractionnaire idéal. Les coefficients des filtres d'interpolation à Réponse Impulsionnelle Finie sont calculés, soit par des méthodes classiques de minimisation de l'erreur quadratique, soit par la méthode de Lagrange.

Dans un deuxième temps, les signaux ainsi retardés subissent chacun un traitement linéaire spécifique, puis sont additionnés. On connaît également les dispositifs similaires utilisés dans une disposition inverse à celle qui vient d'être mentionnée. Dans ce cas, un même signal d'entrée est dupliqué en plusieurs signaux qui lui sont identiques, ces signaux subissant ensuite un traitement linéaire spécifique et une opération de retard fractionnaire spécifique elle aussi. Ces dispositifs sont par exemple utilisés dans le cas des codeurs de parole à résolution fractionnaire du pas, ou du pitch en anglais.

On a représenté, sur les figures 1 à 3, un dispositif numérique connu, dans lequel un nombre M de signaux d'entrée $u_1, u_2,..., u_M$ sont retardés avant de subir un traitement linéaire réalisé par un filtre $T_1$ à $T_M$ et d'être additionnés par un sommateur S. Ce type de dispositif est utilisé dans des applications classiques, comme par exemple le traitement d'antenne, où les retards sont choisis en fonction de l'angle de pointage de l'antenne.

Le retard $r_k$ souhaité est rarement un multiple entier de la période d'échantillonnage. Ce retard $r_k$ est donc constitué d'un nombre entier de périodes d'échantillonnage auquel s'ajoute une fraction de période $\tau$ non nulle. Dans la suite, nous ne considérons pas les retards d'une durée multiple de la période d'échantillonnage, qui sont particulièrement faciles à réaliser. On considérera que les retards à réaliser sont réduits à cette fraction de période d'échantillonnage supplémentaire.

Le dispositif des figures 1 à 3 est alimenté par un nombre M de signaux d'entrée $u_k$ ,où k varie entre 1 et M. Chacun des M signaux d'entrée $u_k$ est, comme représenté sur la figure 1, retardé d'un retard fractionnaire $r_k$ qui lui est propre.

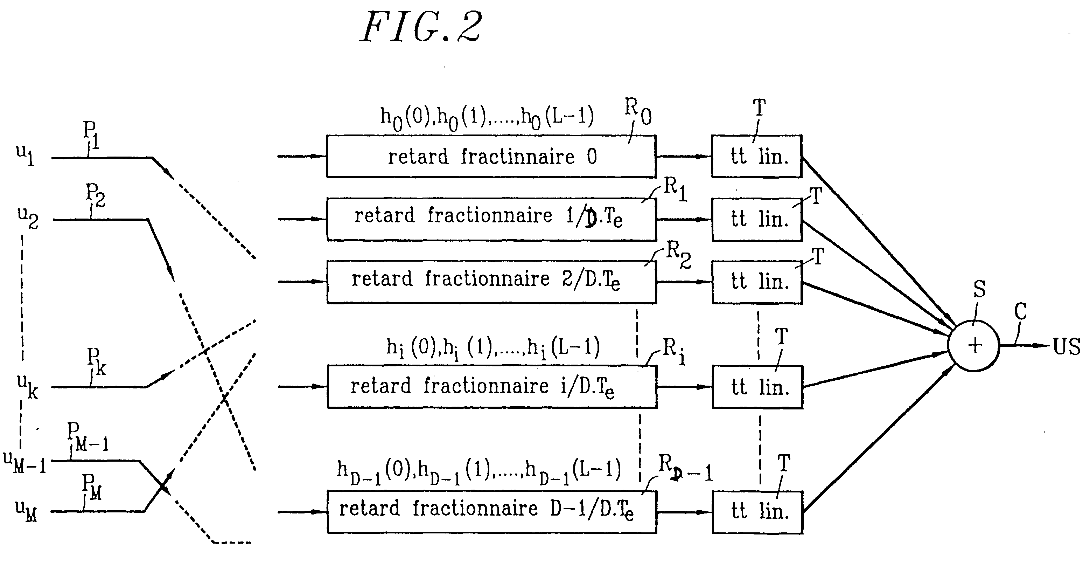

Il existe donc un nombre fini de retards fractionnaires $r_k$ à réaliser. On peut trouver un plus grand commun diviseur $r_o$ de ces retards fractionnaires $r_k$. On réalise en pratique un filtre d'interpolation pour chaque multiple de $r_o$ compris entre 0 et la valeur de la période d'échantillonnage $T_e$. Comme représenté sur la figure 2, on réalise ainsi D filtres d'interpolation $h_i$, référencés $R_0, R_1,...,R_{D-1}$, réalisant des retards de valeur $\frac{i}{D} \times T_e$, où i varie entre 0 et (D - 1).

Un même nombre L de coefficients étant choisi pour chacun des filtres, on réalise donc D filtres $h_i(n)$, où i varie entre 0 et (D - 1) et n varie entre 0 et (L - 1).

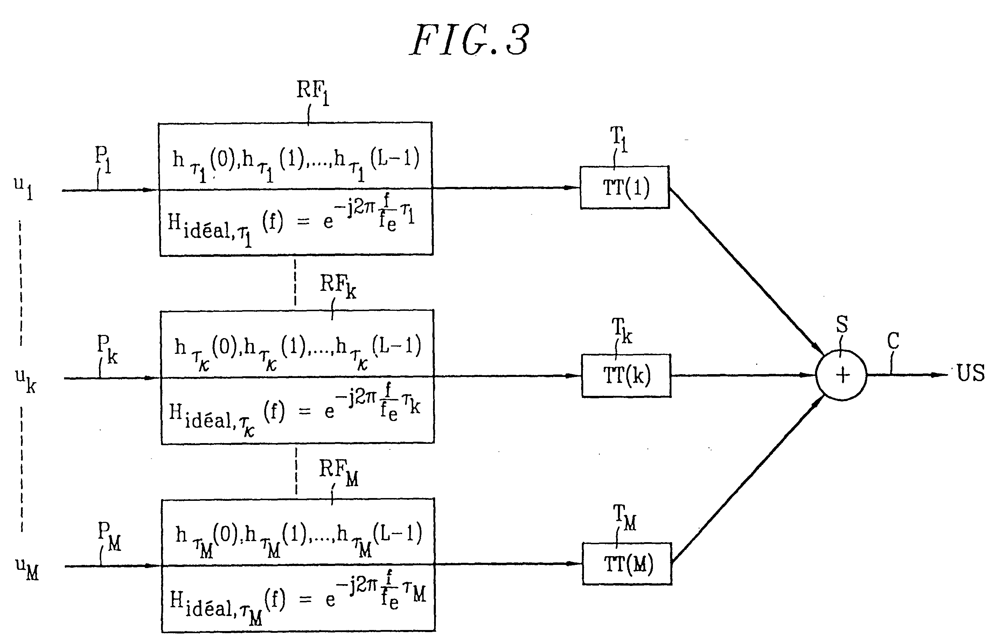

Comme représenté sur la figure 3, à chaque signal d'entrée $u_k$, où k varie entre 1 et M, est appliqué un filtre d'interpolation $h_{\tau k}(n)$, référencé $RF_k$, qui est l'un des D filtres $h_i(n)$ référencés $R_i$ sur la figure 2, i étant compris entre 0 et (D - 1).

On va maintenant rappeler brièvement les formules et les critères utilisés pour calculer les coefficients $h_{i(n)}$ des D filtres d'interpolation $R_0$ à $R_{D-1}$.

Soit $\tau_k$ la valeur du retard fractionnaire normalisé, c'est-à-dire $\tau_k = \frac{r_k}{T_e}$, où $r_k$ est le retard fractionnaire désiré pour ce signal et $T_e$ la période d'échantillonnage.

Soit $u_k(n)$ le signal d'entrée obtenu par échantillonnage d'un signal analogique $u_k^0(t)$. En supposant que l'échantillonnage a été correctement réalisé, on peut en théorie, à partir de $u_k(n)$, obtenir le signal numérique retardé, défini comme l'échantillonnage du signal analogique retardé $u_k^0(t-\tau_k T_e)$. En effet, l'homme de l'art sait qu'à partir du signal $u_k(n)$, dont on connaît tous les échantillons, on retrouve le signal analogique $u_k^0(t)$ correspondant par la formule d'interpolation

$$u_k^0(t) = \sum_{m=-\infty}^{\infty} u_k(m) \frac{\sin\left(\pi\left(\frac{t}{T_e} - m\right)\right)}{\pi\left(\frac{t}{T_e} - m\right)} = \sum_{m=-\infty}^{\infty} u_k(m)\,\mathrm{sinc}\left(\frac{t}{T_e} - m\right)$$

le signal analogique retardé de $r_k$ est alors

$$u_k^0(t - r_k) = \sum_{m=-\infty}^{\infty} u_k(m)\,sinc\left(\frac{t - r_k}{T_e} - m\right) = \sum_{m=-\infty}^{\infty} u_k(m)\,sinc\left(\frac{t}{T_e} - \tau_k - m\right)$$

On obtient ensuite le signal numérique retardé $u_k^{ret}(n)$ par :

$$u_k^{ret}(n) = u_k^0\,(nT_e - r_k)$$

soit :

$$u_k^{ret}(n) = \sum_{m=-\infty}^{\infty} u_k(m)\,sinc(n - \tau_k - m) = h_{idéal,\tau k}(n) * u_k(n)$$

où le signe * symbolise l'opération de convolution et où $h_{idéal,\tau k}(n) = sinc\,(n - \tau_k)$

La fonction de transfert fréquentielle du filtre $h_{idéal,\tau k}$ est

$$H_{idéal,\tau k}(f) = e^{-j2\pi\frac{f}{f_e}\tau_k}.$$

En théorie, il existe donc un filtre idéal $h_{idéal,\tau k}$ permettant d'obtenir le signal échantillonné retardé à partir du signal échantillonné $u_k$.

Un tel filtre n'est pas réalisable en pratique, parce que:

- la sommation est infinie
- le filtre est non causal, c'est-à-dire qu'il faudrait connaître les futurs échantillons pour calculer le résultat.

La non-causalité entraîne qu'on peut seulement approcher une version ayant un retard constant supplémentaire $\tau_0$, noté $h_{idéal,\tau+\tau0}(n)$.

En pratique, et comme représenté à la figure 3, on réalise de manière connue un filtre $h_\tau$ ayant un nombre L fini de coefficients et réalisant une bonne approximation du filtre $h_{idéal,\tau+\tau0}$.

Dans les applications les plus répandues, on se limite à des filtres à Réponse Impulsionnelle Finie. En effet, la conception des filtres à Réponse Impulsionnelle Infinie est plus difficile et demande une meilleure précision de calcul parce que les données sont rebouclées et les erreurs de calcul peuvent s'accumuler. De plus, dans un environnement non stationnaire, comme le traitement d'antenne, la mémoire longue des filtres peut être gênante : il est par exemple difficile de changer brusquement la direction de pointage d'une antenne.

Les filtres passe-tout, un sous-ensemble des filtres à Réponse Impulsionnelle Infinie, ont la propriété favorable d'avoir un module constant. L'absence d'erreur d'amplitude est malheureusement accompagnée d'une augmentation de l'erreur de phase comparée avec des filtres à Réponse Impulsionnelle Finie ayant la même complexité. Pour éviter ces problèmes, on se limite aux filtres à Réponse Impulsionnelle Finie.

Pour calculer les coefficients $h_\tau(n)$ d'un filtre à Réponse Impulsionnelle Finie $h_\tau$ approximant $h_{idéal,\tau+\tau0}$, on connaît différentes méthodes.

Un nombre fini L de coefficients du filtre RIF étant choisi, une première méthode consiste à choisir un jeu de coefficients $h_\tau(n)$ avec n variant entre 0 et (L - 1) qui permette de minimiser l'erreur quadratique $\int |E_\tau(f)|^2 df$, où

$$E_\tau(f) = \sum_{n=0}^{L-1} h_\tau(n)e^{-j2\pi\frac{f}{f_e}n} - H_{idéal,\tau+\tau_0}(f)$$

$f_e$ étant la fréquence d'échantillonnage et l'intégration étant réalisée sur une bande utile de fréquences.

$E_\tau(f)$ est souvent utilisée pour définir des fonctions de coût servant à juger la qualité d'un filtre. Cette méthode est appelée méthode M1. Elle donne comme résultat une version tronquée et retardée du filtre idéal $h_{M1,\tau}(n)=$ sinc(n-$\tau_0$-$\tau$).

Une seconde méthode consiste à calculer d'abord les coefficients $h_\tau(n)$ par la méthode précédente, puis à les multiplier par une fenêtre d'apodisation w(n). Cette méthode est appelée méthode M2. Elle a pour effet de lisser la réponse fréquentielle du filtre.

Si $h_{M1,\tau}(n)$ sont les coefficients du filtre obtenus par la méthode précédente, les coefficients $h_{M2,\tau}(n)$ sont obtenus par la formule $h_{M2,\tau}(n) = h_{M1,\tau}(n).w(n)$ où par exemple w(n)= 0,54 - 0,46.cos $(\frac{2\pi n}{L-1})$ w(n) est connue sous le nom de fenêtre de Hamming.

Une troisième méthode consiste à adopter le jeu de coefficients $h_\tau(n)$ permettant de minimiser l'erreur quadratique généralisée $C_\tau = \int W(f)|E_\tau(f)|^2 df$, où W(f) est une fonction de pondération fréquentielle pouvant être modulée de façon itérative jusqu'à obtenir une fonction $h_{M3\tau}(n)$ satisfaisante et où l'intégration est réalisée sur une bande utile de fréquences. Cette méthode est appelée méthode M3. Elle mène à un système linéaire d'équations.

Une quatrième méthode consiste à adopter les coefficients $h_\tau(n)$ pour lesquels on a

$$\left. \frac{\delta^m E_\tau(f)}{\delta f^m} \right|_{f=0} = 0,$$

où m varie entre 0 et (L - 1). Cette méthode est appelée méthode M4. On obtient les coefficients $h_{M4,\tau}(n)$ par :

$$h_{M4,\tau}(n) = \prod_{\substack{k=0 \\ k \neq n}}^{L-1} \frac{\tau - k}{n - k}$$

On trouvera de nombreux exemples de filtres à réponse impulsionnelle infinie et à réponse impulsionnelle finie de retard fractionnaire, ainsi qu'une comparaison entre ces différents filtres dans l'article du IEEE signal processing magazine, janvier 1996, "Splitting the unit delay, tools for fractional delay filter design", de Laakso, Välimäki, Karjalainen, Laine.

Comme représenté sur la figure 3, on applique donc à chaque signal d'entrée $u_k$ un filtre de retard $h_{\tau_k}(n)$, référencé $RF_k$, où $\tau_k$ est le retard normalisé spécifique au signal $u_k$ et compris parmi les valeurs $\frac{i}{D}$ où i varie entre 0 et (D - 1).

Le dispositif des figures 1 à 3 réalise donc des opérations de retard sur M signaux avec des filtres d'interpolation $RF_1,...RF_M$ de longueur L, ce qui représente $C_1$ = M x L opérations, où l'on définit une opération comme étant une multiplication suivie d'une addition. En outre, la mémoire nécessaire pour stocker les L coefficients des D filtres est $C_2$ = D x L mots.

De tels dispositifs ne donnent pas totalement satisfaction. Si le nombre de signaux à retarder est important, la charge de calcul C1 et le volume de mémoire nécessaire C2 pour stocker les coefficients des filtres d'interpolation sont tellement importants qu'ils rendent les dispositifs extrêmement couteux à réaliser et compromettent par là leur succès économique.

L'objet de l'invention est de proposer un dispositif de traitement numérique qui réalise les mêmes traitements avec la même précision et dont la charge de calcul et la mémoire nécessaires soient nettement diminuées.

Ces buts sont atteints selon l'invention grâce à un dispositif de traitement de signaux numériques véhiculés entre un port commun et M ports particuliers comportant un module de traitement linéaire, et comportant des filtres particuliers qui assurent à la fois un déphasage et une accentuation d'amplitude choisie à chacun des M ports particuliers, ledit déphasage étant spécifique de chaque port particulier et l'accentuation d'amplitude étant sensiblement la même pour tous les ports particuliers, et comportant au dit port commun un filtre d'inversion commun qui réalise une accentuation d'amplitude inverse de la dite accentuation d'amplitude choisie.

Selon l'invention, le port commun peut être un port d'entrée ou de sortie.

D'autres caractéristiques, buts et avantages de la présente invention apparaîtront à la lecture de la description détaillée qui va suivre, et en regard des dessins annexés, donnés à titre d'exemple non limitatif et sur lesquels :

- la figure 1 est une vue schématique sous forme de blocs fonctionnels d'un système numérique connu réalisant sur des signaux d'entrée des opérations de retard fractionnaire et de traitement linéaire spécifiques ;
- la figure 2 représente le même dispositif où l'on a mis en évidence le fait que les filtres de retard fractionnaire sont réalisés avec des retards incrémentaux.

- la figure 3 représente le même dispositif que celui de la figure 1, où l'on a mis en évidence les fonctions de transfert fréquentielles des filtres de retard idéaux qui ont été approchés dans ce dispositif connu ;
- la figure 4 est une vue schématique sous forme de blocs fonctionnels d'un dispositif de traitement numérique conforme à la présente invention ;
- la figure 5 représente le même dispositif que celui de la figure 4 où l'on a mis en évidence des filtres-cibles ayant été approchés.
- la figure 6 représente un dispositif selon l'invention, similaire au dispositif des figures 4 et 5, comportant des filtres de déphasage à quatre coefficients.

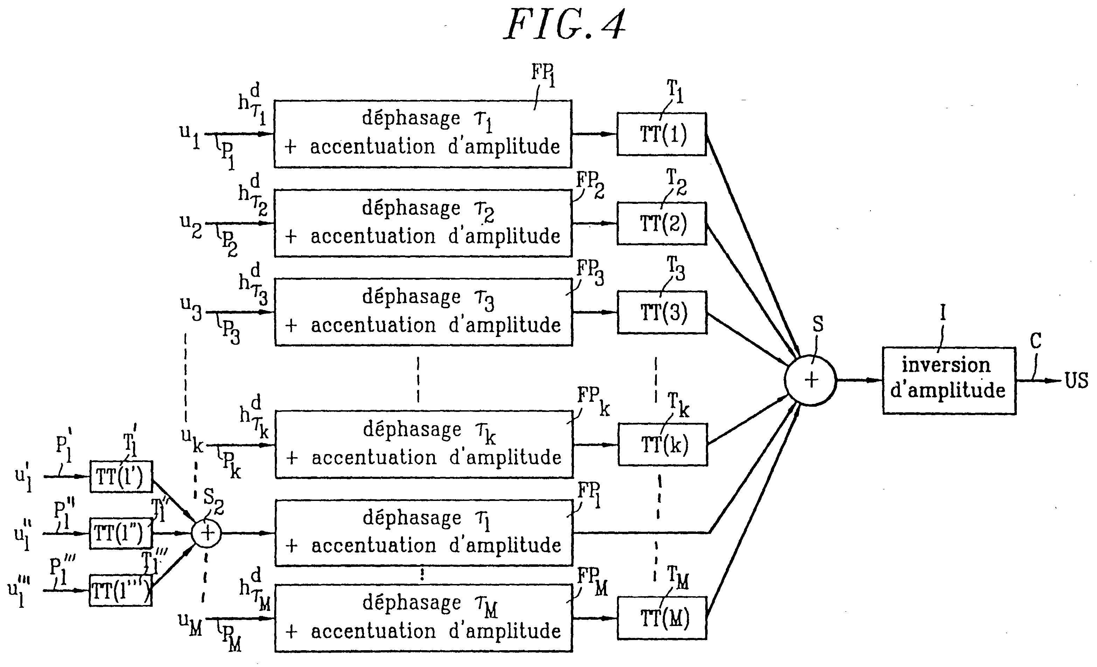

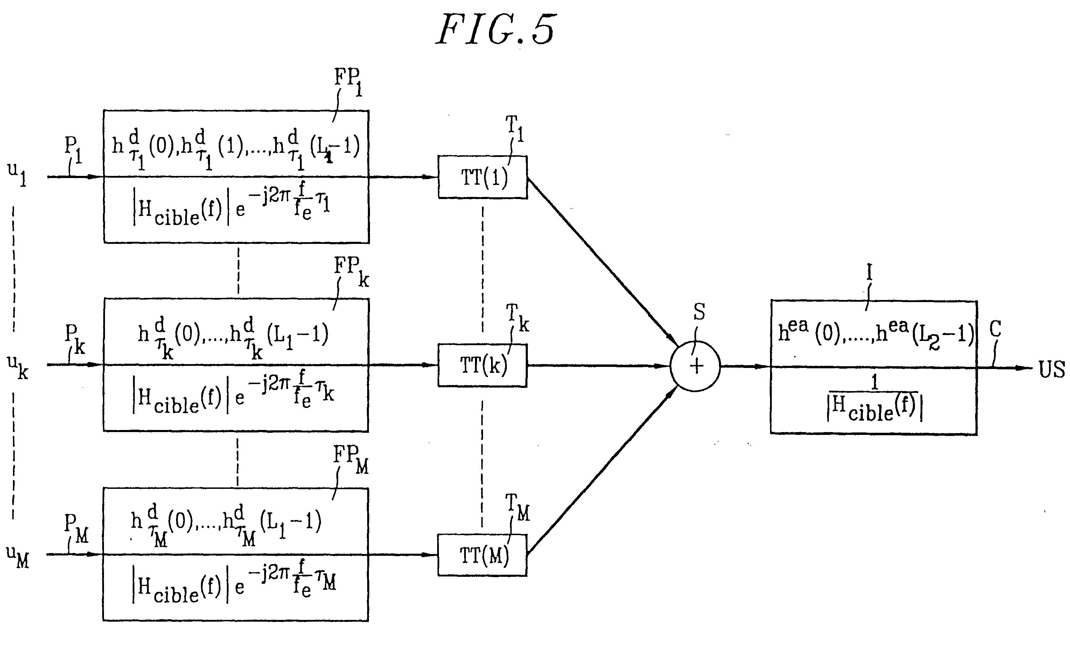

Sur les figures 4 et 5, on a représenté un dispositif selon l'invention qui réalise un traitement de M signaux d'entrée $u_1,...,u_M$ dont le résultat US est le même que celui fourni par le dispositif des figures 1 à 3, et avec la même précision de calcul.

Dans ce dispositif, chacun des M signaux d'entrée $u_k$ passe d'abord par un premier filtre de déphasage $h^d_{\tau_k}$ (n), référencé $FP_k$ sur les figures 4 et 5.

Ces filtres de déphasage $FP_1,...FP_M$ sont des filtres à Réponse Impulsionnelle Finie de longueur $L_1$, approximant chacun un filtre-cible, et dont les coefficients sont calculés par une méthode classique comme M3 indiquée précédemment. Les filtres-cibles ainsi approchés ne sont pas des filtres de retard idéaux comme dans le cas précédent. Les filtres-cibles sont définis dans le domaine fréquentiel par

$$H_{cible,\tau}(f) = |H_{cible}(f)|c^{-j2\pi\frac{f}{f_e}(\tau+\tau_0)},$$

où $(\tau+\tau_0)$ est le retard normalisé, non entier, voulu, $\tau_0$ étant un retard constant supplémentaire, égal à un nombre entier de périodes d'échantillonnage, et où $H_{cible}(f)$ ne dépend que de la fréquence.

Dans la suite, on appellera retard fractionnaire normalisé la partie non entière du retard normalisé effectivement introduit.

La fonction $|H_{cible}(f)|$ est la même pour tous les filtres de déphasage $FP_1$ à $FP_M$. La fonction $|H_{cible}(f)|$ introduit donc sur chaque signal d'entrée une même accentuation d'amplitude d'entrée.

Chaque signal d'entrée $u_k$, après être passé par le filtre de déphasage $h^d_{\tau k}$ référencé $FP_k$ sur les figures 4 et 5, correspondant au retard fractionnaire $\tau_k$ souhaité pour ce signal $u_k$, subit un traitement linéaire TT(k) réalisé par un filtre de traitement linéaire $T_k$ spécifique du signal d'entrée $u_k$. Les signaux sont ensuite sommés.

En aval direct de cette sommation est placé un filtre d'égalisation d'amplitude I, appelé également dans la suite filtre d'inversion commun. Le rôle de ce filtre I est de réaliser l'opération inverse de l'accentuation d'amplitude $|H_{cible}(f)|$ introduite par les filtres de déphasage $h^d_{\tau_k}$ référencé $FP_k$. Dans un mode de réalisation préférentiel de l'invention, il est réalisé en approximant un filtre de fonction de transfert fréquentielle $H_{égal}(f) = \frac{1}{|H_{cible}(f)|}$.

Dans de nombreux cas, le rôle principal du dispositif est de remettre un signal en phase ou un bruit en opposition de phase pour renforcer le signal utile et diminuer le bruit. Dans ces cas, la relation à la fois des phases et des modules des différentes branches entre elles est importante.

Cependant, la non-distorsion globale n'est pas toujours nécessaire. En outre, le filtre d'égalisation I peut être inclus dans un autre filtre qui est nécessaire pour d'autres objectifs, comme l'égalisation d'une fonction de transfert, par exemple celle des capteurs.

Ce filtre d'inversion commun I est ici un filtre RIF. Ses coefficients peuvent être calculés par une des méthodes M1 à M3 décrites précédemment, ou par tout algorithme classique de conception de filtre.

Un filtre linéaire comme le filtre d'inversion commun I produit les mêmes effets sur le signal de sortie US s'il est appliqué à chacun des signaux en amont de la sommation S où s'il est appliqué au signal sommé.

On obtient donc, d'une part, un même traitement des signaux entre les M ports d'entrée $P_1$ à $P_M$ et le port commun de sortie C si un filtre d'inversion commun I unique est placé après la sommation S, ou si M filtres identiques à ce filtre d'inversion commun I sont placés avant la sommation S.

On sait en outre qu'à signal d'entrée donné, un couple de deux filtres linéaires placés en série fournissent un même signal de sortie quel que soit l'ordre dans lequel ils sont placés.

Un filtre d'inversion commun tel que celui des figures 4 à 6 précédemment décrites a donc, d'autre part, les mêmes effets sur le signal de sortie US du dispositif entier s'il est placé juste avant ou juste après chacun des traitements linéaires $T_1$ à $T_M$ spécifiques.

On comprend donc que le filtre d'inversion d'amplitude I commun, placé après la sommation S, produit les mêmes résultats que si M filtres identiques avaient été placés entre chaque filtre particulier de déphasage $h^d_{\tau_k}$ référencé $FP_k$ et le filtre de traitement linéaire TT(k) référencé $T_k$ correspondant.

A la lumière de ces deux explications, on comprend donc que chaque couple filtre de déphasage $FP_k$/ filtre d'inversion commun I disposé selon le schéma de la figure 4 a donc la même incidence sur le signal de sortie US que si chaque couple était placé de manière accolée, à l'emplacement de chaque filtre de déphasage $FP_k$, de manière accolée.

La fonction de transfert de chacun des couples accolés étant égale au produit des fonctions de transfert du filtre de déphasage FP et du filtre d'inversion d'amplitude I, chaque couple constitue donc un filtre dont la fonction de transfert fréquentielle est proche de celle du filtre de retard idéal de fonction de transfert

$$H_{cible,\tau}(f) = e^{-j2\pi\frac{f}{f_e}(\tau+\tau_0)}.$$

Selon une variante de l'invention, le filtre d'inversion I peut également être un filtre à Réponse Impulsionnelle Infinie. Le filtre d'égalisation ou filtre d'inversion d'amplitude I ne variant pas dans le temps, il n'y a pas ici de problème de non-stationnarité.

Si $L_1$ est le nombre de coefficients des filtres de déphasage $FP_1$ à $FP_M$, $L_2$ le nombre de coefficients du filtre d'égalisation I, le dispositif selon l'invention réalise donc $C_1 = M \cdot L_1 + L_2$ opérations, une opération étant une multiplication suivie d'une addition.

Le dispositif stocke en mémoire les coefficients de D filtres de longueur $L_1$ et d'un filtre de longueur $L_2$, ce qui représente un volume de mémoire de $C_2 = D \cdot L_1 + L_2$ mots.

Le nombre M de signaux d'entrée est en pratique très élevé.

Pour un filtre de retard fractionnaire $h_\tau(n)$ de référence donné, de longueur L, les inventeurs ont constaté après de longues recherches qu'on peut réaliser un couple filtre de déphasage $FP_M$/filtre d'inversion d'amplitude I dont le filtre de déphasage $FP_k$ a un nombre $L_1$ de coefficients qui est inférieur à L, voire très petit devant L, et tel que la précision de calcul de ce couple de filtres soit similaire à celle du filtre $h_\tau(n)$ de référence.

On choisit pour cela, de préférence, une fonction d'accentuation $|H_{cible}(f)|$ lisse et qui a des valeurs faibles à la demi fréquence d'échantillonnage.

Ces fonctions $|H_{cible}(f)|$ sont avantageusement choisies parmi les fonctions de la forme

$$|H_{cible}(f)| = X + Y\left(1 + \cos\left(\frac{2\pi f}{f_e}\right)\right),$$

le rapport X/Y étant préférentiellement compris entre 0 et 0,3.

Afin de normaliser la valeur de $|H_{cible}(f)|$ à $f = 0$, X et Y vérifient de préférence la relation $X + 2Y = 1$.

Un choix préférentiel de fonction $|H_{cible}(f)|$ est $|H_{cible}(f)| = 0,06 + 0,47 \left(1 + \cos\left(\frac{2\pi f}{f_e}\right)\right)$. Avec cette fonction $|H_{cible}(f)|$, on calcule avantageusement les coefficients des filtres avec la méthode M3 et la fonction W(f) =1 pour $f < \frac{6}{16}f_e$; W(f) = 5 pour $\frac{6}{16}f_e \leq f < \frac{7}{16}f_e$ ; W(f) = 0,01 pour $f > \frac{7}{16}f_e$.

On a donc alors $L_1 < L$, voire $L_1 << L$, et $M >> 1$, ce qui implique :

$M.L_1 + L_2 << M.L$ et $D.L_1 + L_2 << D.L$.

La charge de calcul et le volume de mémoire nécessaire sont donc fortement réduits.

La charge de calcul et le volume de mémoire nécessaire peuvent être réduits encore lorsque, comme représenté à la figure 4, plusieurs signaux d'entrée $u_1'$, $u_1''$, $u_1'''$ sont à retarder avec un même retard fractionnaire $\tau_1$.

On place dans ce cas un sommateur $S_2$ de ces signaux en amont d'un filtre de déphasage $FP_1$ qui réalise un même déphasage $\tau_1$ sur la somme des signaux.

S'il y a besoin d'un traitement linéaire individuel TT(1'), TT(1''), TT(1''') respectivement pour chaque signal d'entrée $u_1'$, $u_1''$, $u_1'''$, il est alors nécessaire de placer des filtres de traitement linéaire $T_1'$, $T_1''$, $T_1'''$ en amont de ce sommateur $S_2$, appliqués à chaque signal d'entrée $u_1'$, $u_1''$, $u_1'''$.
Cette disposition permet d'obtenir un dispositif dans lequel on ne trouve pas de filtres de déphasage identiques en double. On ne réalise-donc pas les mêmes opérations en deux endroits différents et on ne stocke pas deux fois le même jeu de coefficients.

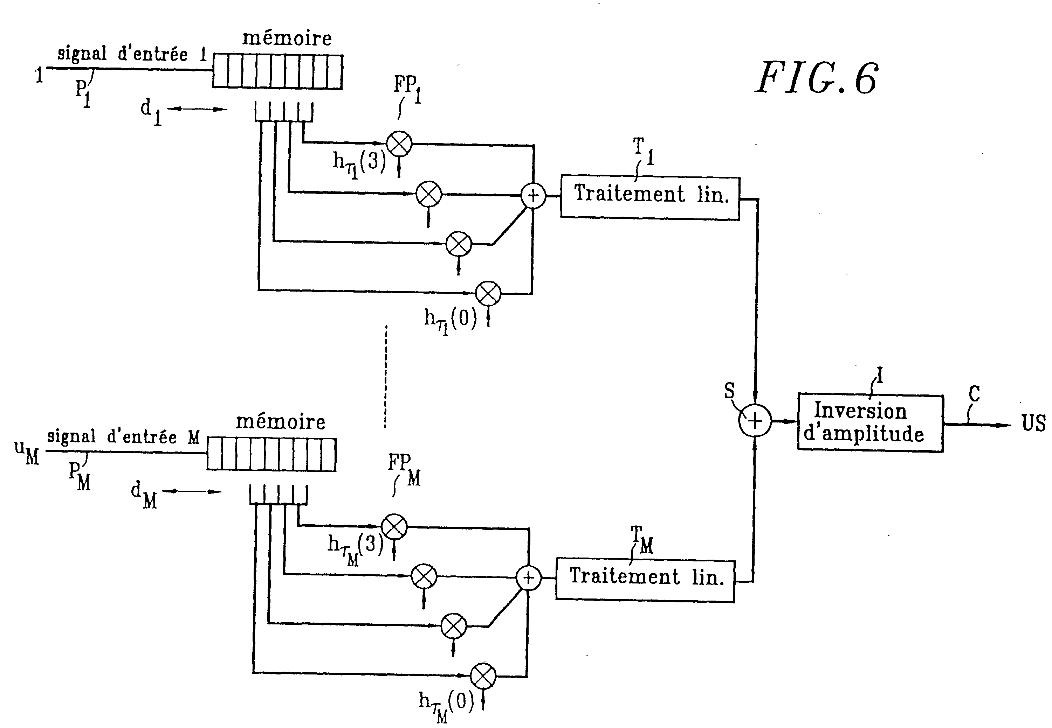

On présente ici un exemple de réalisation pratique d'un tel dispositif représenté schématiquement sur la figure 6.

Dans cet exemple numérique, la bande utile des signaux d'entrée est 0 - 7 kHz. La fréquence d'échantillonnage $f_e$ est prise égale à 16 kHz. Le nombre D de filtres à réaliser, appelé aussi résolution, est égal à 20. Le nombre d'entrées est M = 32. La longueur des filtres de déphasage est L1 = 4 coefficients, la longueur du filtre RIF d'inversion commun est $L_2 = 11$ coefficients.

On calcule les quatre coefficients de chaque filtre de déphasage par l'algorithme des moindres carrés généralisé, ou méthode M3, et les sept coefficients du filtre d'inversion d'amplitude par un algorithme classique de conception de filtres à Réponse Impulsionnelle Finie à phase linéaire. Les coefficients des filtrés sont normalisés pour un calcul sur un DSP virgule fixe 16 bits.

On trouve les coefficients suivants :

| i | $\tau_i = \frac{i}{D}$ | $h_i(0)$ | $h_i(1)$ | $h_i(2)$ | $h_i(3)$ |
|---|---|---|---|---|---|
| 0 | 0 | 14520 | 32767 | 14513 | -19 |
| 1 | 0.05 | 13290 | 32697 | 15779 | 198 |
| 2 | 0.1 | 12089 | 32504 | 17067 | 449 |
| 3 | 0.15 | 10926 | 32189 | 18368 | 741 |
| 4 | 0.2 | 9806 | 31756 | 19672 | 1078 |
| 5 | 0.25 | 8737 | 31208 | 20968 | 1466 |
| 6 | 0.3 | 7723 | 30550 | 22246 | 1909 |
| 7 | 0.35 | 6769 | 29789 | 23494 | 2410 |
| 8 | 0.4 | 5878 | 28931 | 24703 | 2973 |
| 9 | 0.45 | 5052 | 27985 | 25861 | 3600 |
| 10 | 0.5 | 4293 | 26958 | 26958 | 4293 |

Les valeurs pour i = 11, ...,19 sont calculées par une relation de symétrie $h_i(n) = h_{D-i}(L_1-1-n)$ dans le cas présent où le retard supplémentaire $\tau_0$ est égal à $(L_1-2)/2$.

On va maintenant démontrer cette propriété :

Un filtre RIF de longueur $L_1$ peut prendre des valeurs non nulles pour n = 0,...,$L_1$-1. Le point au milieu de la réponse impulsionnelle est donc $(L_1-1)/2$. Les retards proches de cette valeur sont plus faciles à obtenir que d'autres. C'est la raison pour laquelle on cherche dans un mode de réalisation préférentiel de l'invention à approcher un dé-phasage idéal normalisé de $\tau+\tau_0$ où $\tau_0$ est fixé à $(L_1-2)/2$ et le retard fractionnaire normalisé $\tau$ varie entre 0 et 1, ce qui donne une plage de retards normalisés qui varie de $(L_1-2)/2$ à $L_1/2$, et qui est symétrique par rapport au centre $(L_1-1)/2$.

On sait de plus que si

$$\tilde{h}(n) = h(L_1-1-n),$$

on a

$$\tilde{H}(f) = H^*(f)e^{-j2\pi f(L1-1)}$$

où $H^*(f)$ est le conjugué complexe de $H(f)$

Or $H_\tau(f)$ approche

$$|H_{cible}(f)|.H_{idéal,\tau+\tau0}(f) = |H_{cible}(f)|e^{-j2\pi f(\tau-\tau_0)}$$

$$= |H_{cible}(f)|e^{-j2\pi f(\tau+(L_1-2)/2)}$$

alors

$$\tilde{H}_\tau(f) = H^*(f)e^{-j2\pi f(L1-1)}$$

approche

$$|H_{cible}(f)|.\ H^*_{idéal,\tau+\tau0}(f)e^{-j2\pi j(L_1-1)}$$

$$= |H_{cible}(f)|.\ e^{+j2\pi f(\tau+\tau_0)}e^{-j2\pi f(L_1-1)}$$

$$= |H_{cible}(f)|.\ e^{-j2\pi f(L_1-1\ -\ (L_1-2)/2\ -\tau)}$$

$$= |H_{cible}(f)|.\ e^{-j2\pi f((L_1-2)/2+\ 1\ -\tau)}$$

$$= |H_{cible}(f)\ |\ H_{idéal,\ (1\ -\tau)\ +\ \tau0}\ (f)$$

donc $\tilde{H}_\tau$ (f) approche $H_{1\ -\tau}$(f) et $\tilde{H}_{1-\tau}$ (f) approche $H_\tau$(f) d'où $h_\tau$ sensiblement égal à $h_{1-\tau}$, c'est-à-dire : $h_\tau(n) = h_{1-\tau}(L_1-1-n)$ quel que soit n compris entre 0 et $L_1$-1.

Cette relation de symétrie permet de ne stocker en mémoire que les coefficients de la moitié des filtres nécessaires.

Il suffit pour cela de ne stocker, comme dans l'exemple exposé ici, que les coefficients des filtres $h_\tau$ correspondant à des retards normalisés $(\tau+\tau_0)$ situés entre $\frac{(L_1\ -\ 2)}{2}$ et $\frac{(L_1\ -\ 1)}{2}$. Les filtres $h_{1-\tau}$ correspondant à des retards normalisés $1-\tau+\tau_0$ symétriques de ces retards $\tau+\tau_0$ par rapport à $(L_1-1)/2$ sont déduits par la relation de symétrie $h_\tau(n) = h_{1-\tau} (L_1-1-n)$. De cette façon, pour deux filtres de déphasage dont les retards fractionnaires normalisés respectifs sont symétriques par rapport à un retard fractionnaire égal à la demi-période d'échantillonnage, les coefficients d'un des deux filtres sont déduits de ceux de l'autre par la relation ci-dessus mentionnée.

Pour le filtre d'inversion d'amplitude à Réponse Impulsionnelle Finie, on trouve pour $h_{egal}(n)$ variant entre 0 et $L_2$-1 = 10 : -217, 747, -2914, 8225, -18117, 32767,-18117, 8225, -2914, 747, -217.

Si la phase ne doit pas être strictement linéaire, on peut utiliser un filtre à Réponse Impulsionnelle Infinie d'ordre 3 avec L2 = 7 coefficients dont les zéros sont : -0.655 et 0.0016 ± 0.0383i, et dont les pôles sont: -0.7089, et -0.5891 ± 0.2122i. Ce filtre est par exemple calculé par l'algorithme de Yule-Walker connu en soi.

La nouvelle structure est équivalente à une structure classique avec des filtres d'interpolation $h_{total}$, où $h_{total}$ (n) = $h_i(n)$*$h_{égal}(n)$, * étant l'opération convolution.

Dans le cas de ce dispositif, la charge de calcul est donc $C_1 = M.L_1 + L_2 = 32 \times 4 + 7 = 135$ opérations et la mémoire nécessaire est $C_2 = D.L_1 + L_2 = 20 \times 4 + 7 = 87$ mots. La structure de ce filtre est représentée sur la figure 6 sous forme d'un ensemble de blocs fonctionnels.

Dans le cas d'un traitement d'antenne, on choisit les retards $R_i$, avec i variant entre 1 et M, par exemple en fonction de l'angle de pointage de l'antenne.

Ensuite, les retards sont normalisés et quantifiés. On obtient les parties entières $d_i$ et les parties fractionnaires $r_i$ des retards normalisés par : $r_{nq.i} = \frac{round\ (D.R_i.f_c)}{D}$, $d_i = floor(r_{nq.i})$ et $r_i = r_{nq,i} - d_i$, où les fonctions round et floor sont respectivement les fonctions approximation entière et partie entière.

Le dispositif numérique ainsi réalisé a été comparé avec un filtre de structure connue telle que représentée sur les figures 1 à 3, où les coefficients des filtres de retard fractionnaire ont été calculés avec :

. la méthode M1 et avec L=20 (C1 = 640 opérations, C2 = 400 mots)
. la méthode M2, avec une fenêtre de Hamming et avec L=18 (C1 = 576, C2 = 360)
. la méthode M2, avec une fenêtre de Blackman et avec L=24 (C1 = 768, C2 = 480)
. la méthode M3, avec L=12 et avec W(f)=1 dans la bande utile 0-7kHz (C1 = 384, C2 = 240)
. la méthode M3, avec L=13 et avec W(f)=1 dans la bande utile 0-7kHz (C1 = 416, C2 = 260)
. la méthode M4, avec L=30 (C1 = 960, C2 = 600)

On a également représenté les résultats obtenus avec un dispositif selon l'invention, dont les filtres de déphasage ont six coefficients et dont les coefficients sont calculés avec les mêmes méthodes que pour le filtre selon l'invention à quatre coefficients précédemment décrit.

Les filtres idéaux ont une phase φ qui décroît linéairement avec la fréquence f. la fraction $\frac{-\varphi}{(2\pi f)}$, nommée "retard de phase" est donc dans le cas idéal une constante.

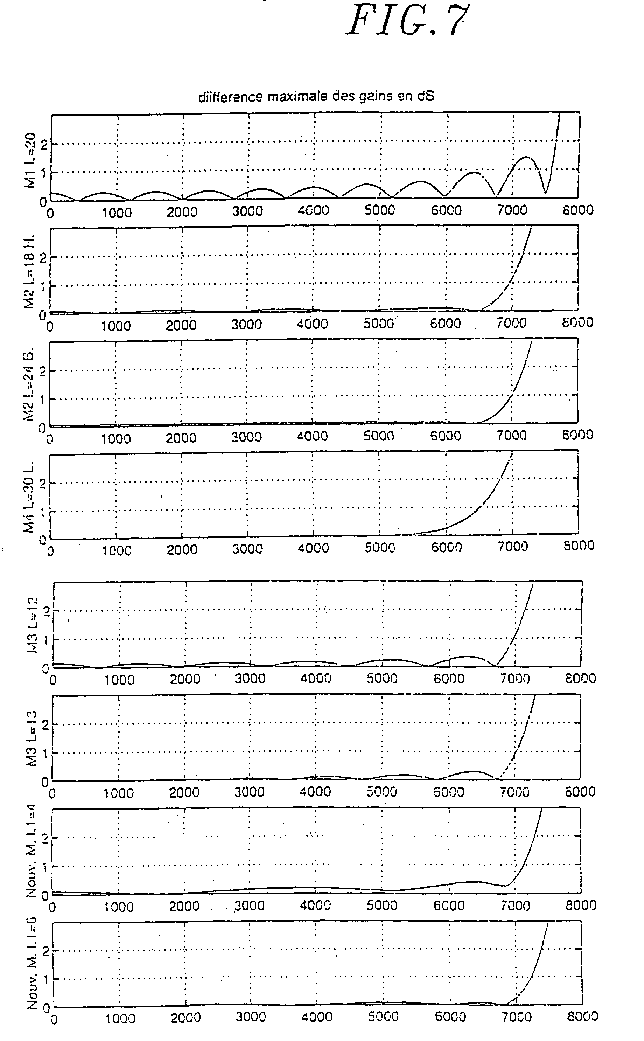

La figure 7 montre les différences maximales entre les modules, c'est-à-dire $max_{\tau_1.\tau_2} (||H_{\tau_1}(f)|-|H_{\tau_2}(f)||)$ pour D=20 retards fractionnaires.

Elle permet de juger la qualité des filtres déphaseurs de la nouvelle méthode. En effet, le filtre d'inversion d'amplitude ne modifie pas la différence des modules, c'est-à-dire qu'on obtient les mêmes résultats pour $H_{total}(f) = H_\tau^d(f)H_{égal}(f)$ et pour $H_\tau^d(f)$ tout seul. Cette figure sert donc à juger la qualité des filtres de déphasage $h_\tau^d$.

L'ordre des autres filtres a été choisi pour avoir une erreur d'amplitude maximale d'environ 1dB, ce qui correspond à un facteur de 1.12. Dans le pire des cas, on risque donc d'avoir un résidu dû à l'erreur de l'amplitude de 0.12 (-18dB) au lieu d'une annulation pour une interférence destructive.

On peut constater que les performances de tous les filtres sont excellentes pour les basses fréquences jusqu'à 6kHz à l'exception de la méthode M1. L'erreur maximale se situe toujours à la fréquence maximale de 7kHz. Les deux exemples de la nouvelle méthode ont les erreurs maximales les plus faibles. Les performances globales sont satisfaisantes pour le filtre à quatre coefficients et excellentes pour le filtre à six coefficients qui montre les meilleurs résultats de tous les filtres.

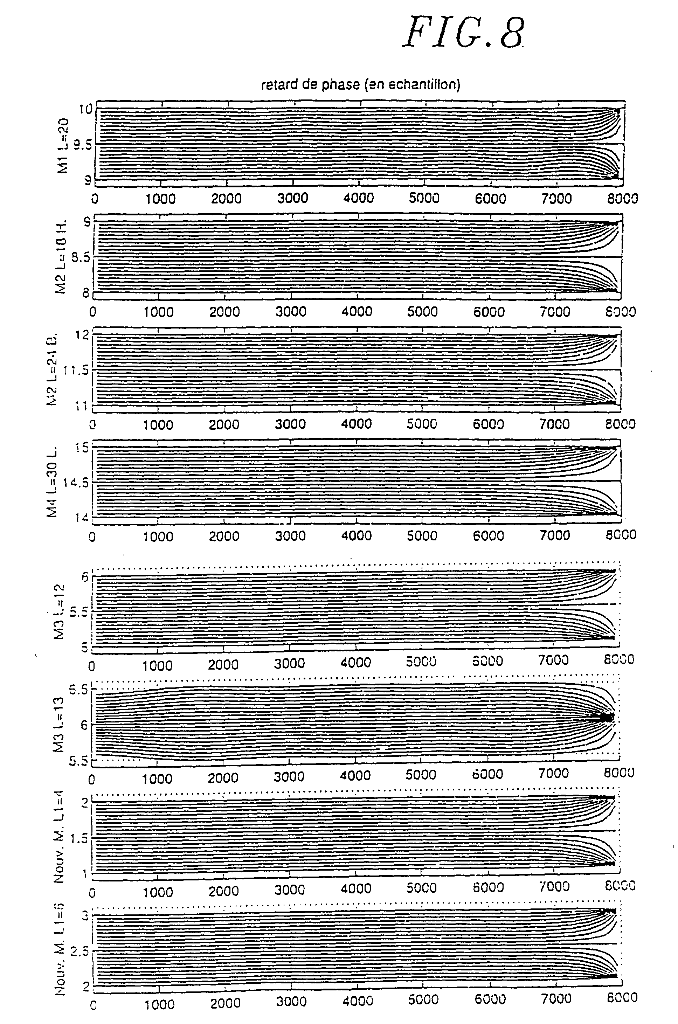

La figure 8 montre les retards de phase $-\frac{\psi_\tau(f)}{2\pi f}f_e$ où $\varphi_\tau(f)$ est la phase du filtre $h_\tau^d$ et $f_e$ est la fréquence d'échantillonnage. Il est difficile de juger la qualité de la phase à l'aide de cette figure, parce que les erreurs dans les basses fréquences sont accentuées par le dénominateur et parce qu'il n'est pas facile de comparer deux méthodes. Elle est incluse ici pour montrer qu'un filtre de longueur paire peut être exact pour la phase pour des retards entiers et entier et demi (nommés filtres à phase linéaire) tandis qu'un filtre de longueur impaire ne peut pas être exact pour un retard entier et demi. C'est la raison principale pour laquelle les filtres de longueur impaire sont rarement utilisés.

La figure 8 montre aussi qu'à la fréquence maximale les retards tendent vers les valeurs entières à l'exception du retard entier et demi. Ce comportement est dû à l'effet que la transformation de Fourier discrète d'une suite réelle est toujours réelle pour la fréquence maximale. Il en suit que la phase est soit zéro soit $\pi$ soit indéfinie parce que le module est zéro. Ceci explique pourquoi la phase des filtres s'éloigne de la valeur cible pour les hautes fréquences.

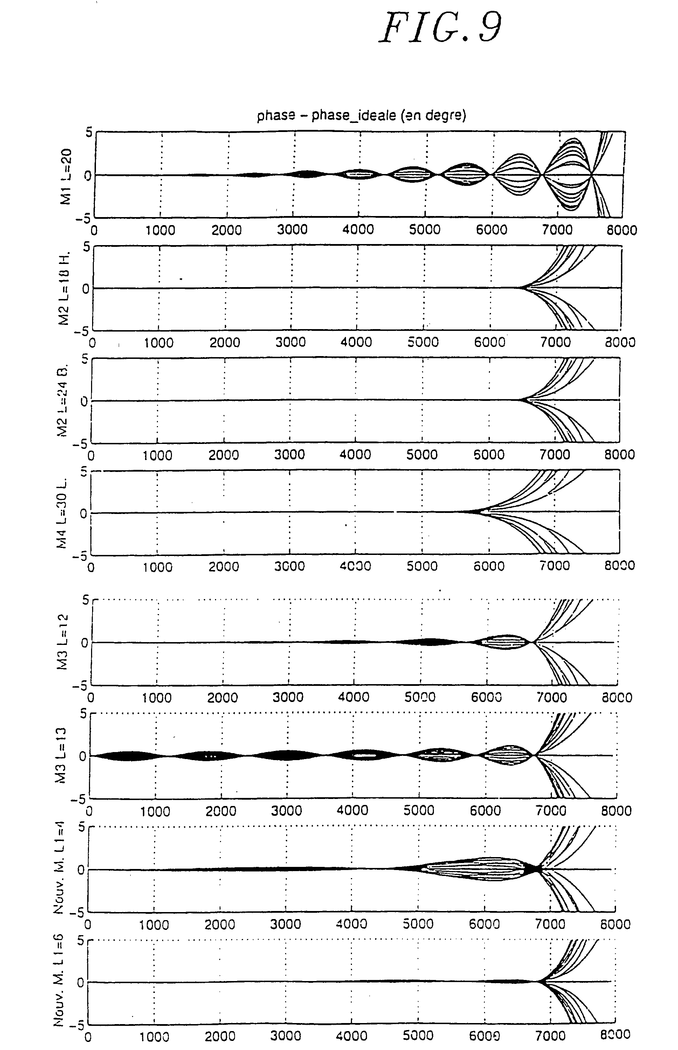

La figure 9 montre l'erreur de phase $[\varphi_\tau(f) - \varphi_{\tau,idéal}(f)]$, c'est-à-dire une autre représentation du déphasage. Elle est bien adaptée pour comparer la qualité de la phase des filtres. Les plus grandes erreurs de phase se produisent toujours à la fréquence utile maximale de 7kHz. Le filtre avec quatre coefficients montre des erreurs de phase un peu plus grandes que la plupart des autres filtres. En revanche, la nouvelle méthode présente les deux erreurs maximales les plus faibles.

La figure 9 permet aussi d'évaluer à quelle précision quantifier le retard. Il est inutile de stocker un grand nombre de filtres si les filtres ne sont pas suffisamment exacts. A la fréquence maximale, un retard d'un échantillon correspond à un déphasage de 180 degrés. Vu l'erreur maximale de phase d'environ 3 degrés, il est donc raisonnable de stocker plus que 60 filtres pour que l'erreur de quantification du retard soit inférieure à l'erreur introduite par le filtre. Si la mémoire libre ne permet pas de stocker autant de filtres, on dégrade les performances. Ce cas peut se produire dans des environnements temps réel typiques, par exemple pour la mémoire interne d'un DSP. La nouvelle structure permet dans ce cas d'obtenir de meilleurs résultats avec une complexité réduite.

On peut constater que les filtres de Lagrange ont des excellentes performances pour les basses fréquences, mais le nombre de coefficients croît rapidement avec la bande utile de fréquence. Pour assurer un bon comportement pour la bande 0-7kHz, un nombre excessif de coefficients est nécessaire.

Dans le pire des cas (hormis Lagrange), la différence maximale de phase est égale à 7 degrés, ce qui entraîne le même résidu de 0.12 (-18dB) que celui dû à l'erreur de l'amplitude.

On constate donc que même le cas critique d'une interférence destructive peut être traité avec seulement quatre opérations par entrée et quatre coefficients à stocker pour chaque retard fractionnaire. La comparaison avec les filtres d'interpolation classiques (méthodes 1 à 3) montre qu'on peut obtenir simultanément :

- une réduction d'un facteur entre 3 et 8 de la charge de calcul
- une réduction d'un facteur entre 3 et 8 de la mémoire nécessaire

avec une erreur maximale plus petite et des bonnes performances globales.

La méthode est particulièrement adaptée à la formation de lobes pour le traitement d'antenne, car l'interpolation est souvent l'opération la plus coûteuse du traitement. Les figures avec L1=6 montrent que cette méthode est également très efficace pour des applications qui demandent une très haute précision.

On notera que ces deux exemples de filtres couvrent une majeure partie des applications actuelles des filtres à retard fractionnaire.

En effet, il est rare d'une part de chercher à obtenir des filtres de retard ayant moins de quatre coefficients, et on a rarement besoin d'une meilleure précision que celle obtenue avec le deuxième exemple où $L_1 = 6$.

On donne à la suite de la description un exemple de réalisation d'un filtre numérique selon l'invention et conforme à celui décrit ci-dessus, où les paramètres $L_1$, $L_2$ et D sont respectivement égaux à 4, 19 et 60. Cet exemple est donné à titre illustratif, sous forme de programme en langage C. Les coefficients de la routine filter 1.C ont été calculés par avance avec les fonctions $|H_{cible}(f)|$ et W(f) mentionnées précédemment.

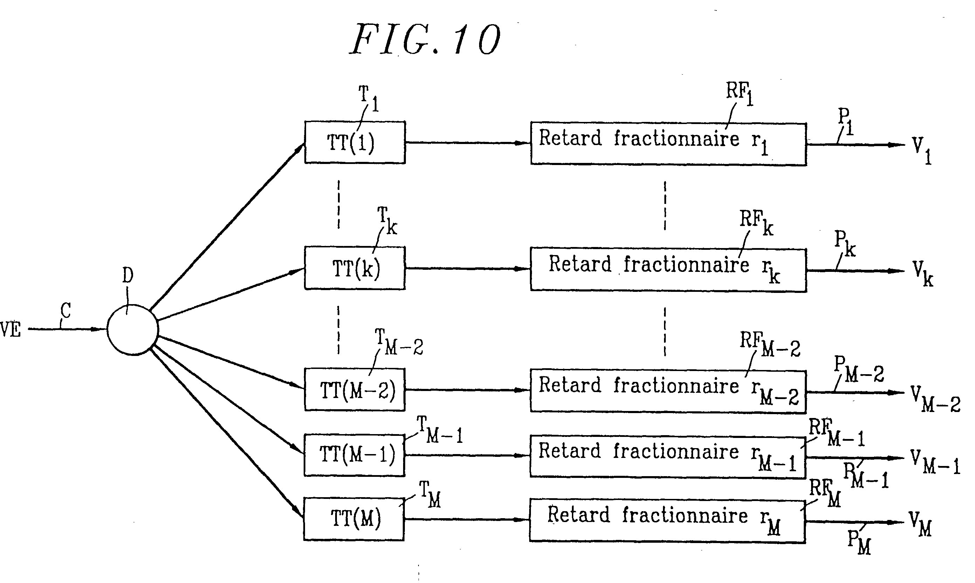

Le dispositif connu de la figure 10 a pour objet de fournir M signaux de sortie, référencés $V_k$ où k varie entre 1 et M, spécifiques, résultant chacun d'un traitement linéaire TT(k) réalisé par un filtre $T_k$ suivi d'un retard fractionnaire réalisé par un filtre $RF_k$, à partir du même signal d'entrée VE.

Ce problème se pose par exemple pour les codeurs de parole à résolution fractionnaire du pitch. Plusieurs codeurs de parole utilisent les équations suivantes pour déterminer le pitch P :

$$x = (x(n),x(n-1),...,x(n-N+1)),$$

$$y = (x(n-P),x(n-P-1),...,x(n-P-N+1))$$

$$P = \mathrm{argmax} \frac{< x,y >}{\|y\|^2}$$

pour obtenir une résolution fractionnaire du pitch P, on doit retarder le signal x d'un retard fractionnaire.

Comme représenté à la figure 10, ce dispositif comporte en amont un dispositif D qui duplique d'abord le signal d'entrée VE en M signaux VE' qui lui sont identiques, puis chacun de ces signaux VE' passe par un filtre de traitement linéaire $T_k$ réalisant un traitement linéaire TT(k), suivi d'un filtre de retard fractionnaire $RF_k$ introduisant un retard fractionnaire $r_k$.

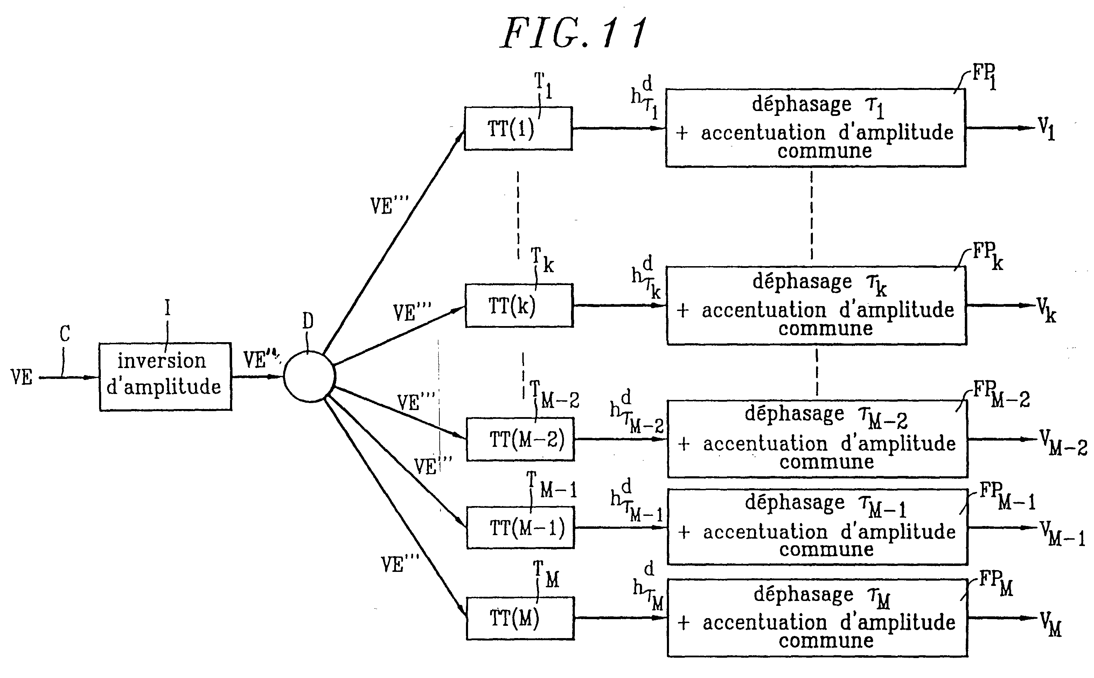

La figure 11 représente un dispositif de traitement numérique conforme à la présente invention, dans lequel un unique signal d'entrée VE est traité pour fournir M signaux de sortie $V_1$ à $V_M$ similaires à ceux obtenus avec le dispositif de la figure 10. On retrouve les éléments similaires à ceux du dispositif des figures 4 à 6 c'est-à-dire des filtres de déphasage $h_{\tau_k}^d (n)$, où k varie entre 1 et M, référencés $FP_1$, $FP_2$,..., $FP_M$, des filtres de traitement linéaire $T_k$, où k varie entre 1 et M, et un filtre d'inversion d'amplitude I.

Le filtre d'inversion d'amplitude I est appliqué au signal d'entrée VE, sur lequel il réalise une préaccentuation d'amplitude. Plus précisément, la fonction de transfert de ce filtre I a un module non constant, et une phase nulle. Le signal ainsi obtenu, référencé VE'', est ensuite dupliqué par un dispositif D en M signaux identiques VE'''. Chacun de ces signaux VE''' subit un traitement linéaire spécifique TT(k) (k varie entre 1 et M), réalisé par un filtre $T_k$, puis passe par un filtre de déphasage spécifique $h^d_{\tau_k}$ référencé $FP_k$.

Ces filtres de déphasage $FP_k$ sont chacun une approximation d'un filtre-cible dont la fonction de transfert a les caractéristiques suivantes : sa phase est proche de celle du filtre de retard fractionnaire idéal introduisant le retard $r_k$ voulu pour le signal de sortie, c'est-à-dire que sa phase est proche de $-2\pi r_k f$.

Son module est la fonction inverse du module du filtre d'inversion d'amplitude I placé en amont du dispositif. Comme dans le cas du dispositif des figures 3 et 4, on comprend que le filtre d'inversion d'amplitude I a les mêmes effets que s'il était appliqué à chaque signal dupliqué, juste avant les filtres de déphasage $h^d_{\tau_k}$ référencés $FP_k$, où k varie entre 1 et M.

Dans le cas de la figure 10, la charge de calcul est, tout comme dans le cas des figures 1 et 2, $C_1 = M \times L$ opérations. On stocke, pour les mêmes raisons, D filtres de longueur L, soit $C_2 = D \times L$ mots en mémoire, alors que dans le cas du dispositif de la figure 11, la charge de calcul est $C_1 = M \times L_1 + L_2$ opérations et la mémoire nécessaire $D \times L_1 + L_2$ mots, où $L_1$ est la longueur des filtres de déphasage, et où $L_2$ est la longueur du filtre d'inversion d'amplitude.

De la même façon que précédemment, on peut obtenir un couple filtre de préaccentuation d'amplitude I/filtre de déphasage $FP_k$ ayant les mêmes performances qu'un filtre de retard fractionnaire $RF_k$ de longueur L, et dont la longueur $L_1$ du filtre de déphasage $FP_k$ soit inférieure, voire très petite devant la longueur L du filtre de retard $RF_k$. Le dispositif de la figure 11 produit alors les mêmes résultats, avec la même précision que le dispositif de la figure 10 et avec une charge de calcul et un volume de mémoire nécessaire nettement diminués.

Bien sûr, l'invention n'est pas limitée aux exemples de réalisation décrits. Elle s'étend à toute variante conforme à l'objet de la demande défini dans les revendications.

Notamment, le filtre d'accentuation d'amplitude commun I pourra en même temps servir pour égaliser une fonction de transfert, par exemple celle d'un capteur.

Plus généralement, l'invention n'est pas limitée aux filtres d'interpolation mais peut servir pour d'autres traitements linéaires avec soit un grand nombre d'entrées soit un grand nombre de sorties.

```
Programme  en  C
programme  main.c  page  1
/* application to beamforming algorithm */


#include "cons.h"
#include <stdio.h>
#include <math.h>


/* antenna geometrie */
const float xposition[]={O,.1,.2,.3,.4,.5,.6,.7,.8,.9};
const float xmin=0;
const float xmax=.9;


/* filterl for phase shift introducing amplitude distortion */
/* filter2 for amplitude egalisation */
long filterl(short*, int, struct delay*, float*);
int filter2(long*);
struct delay *calcdelay(float,int);


int main(int argc, char*argv[])
{
    /**********************************************************/
    /* declaration */

    struct delay *del;     /* integer and fract. part*/


    char *infile,*outfile,*parfile;/*  file names */


    int i,m;                    /* loop variables */
    int delmax,base;            /* max. delay, address offset */
    int neof,                   /* not_end_of file */
    long outl;                  /* output filter 1 */
    short out2;                 /* output filter 2 */


    float phi                   /* steering angle */
    float shaping[M};           /* microphone weighting */
```

```
short indata[INBUFFER][M];      /*input buffer */
long outdata[L2];               /* buffer for second filter */

FILE *infpt,*outfpt,*parfpt;    /*file pointer */


/**********************************************************/
/* get command line parameters infile, outfile, parameter file*/
if (argc!=4)
{
                                printf("use frac in_file out_file
parameter_file\n");
    return(-1 );
}

infile=argv[1];outfile=argv[2]; parfile=argv[3];

infpt=fopen(infile,"rb");outfpt=fopen(outfile,"wb");parfpt=fopen
(parfile,rb");

if ((infpt==NULL) | (outfpt==NULL) | (parfile==NULL))
{
    printf("unable to open input or output or parameter file");
    return(-2);
}


/**********************************************************/
 /* maximum delay */

delmax =(int) ((xmax-xmin)*Fs/c);
if (delmax+L1 >INBUFFER)
{
    printf("Input Buffer too small");
    return(-3);
}
```

```
programme  main.c  page  2
/****************************************************/
/* get multiplexed input data from infile and put into indata */
fread(indata,M*sizeof(short),(delmax+L1),infpt);


base=delmax+LI;


/****************************************************/
/* main loop for each sample */
for (neof= 1;neof>0;)
{
        /* read input data and steering parameters */
        base=( (base+1)%INBUFFER);
        fread(&indata[base][0],M*sizeof(short),1,infpt);
        neof=fread(&phi,sizeof(float),1,parfpt);
        fread(shaping,sizeof(float),M,parfpt);


        /* compute integer and fractionnal delay for each
        microphone */
        del=calcdelay(phi,delmax);


        /* beamforming by delay-weighting-sum */
        out1=filter1(&indata[0][0],base,del,shaping);


        /* the second filter shift loop */
        for (i=O;i<L2-1;i++)
                outdata[i]=outdata1[i+1];
        outdata[L2- 1]=out 1;


        out2=filter2(outdata);


        fwrite(&out2,sizeof(short),1,outfpt);
}
return(0);
}
```

```
programme  filterl.c  page  1

/* performs delay - weighting - sum beamforming */
/* Wolfgang Tager, 28.10.96 */


#include "cons.h"
#include "math.h"


float abs(float); /* since default is int */


long  filterl(short  indata[INBUFFER][M],int  base,struct  delay
*del,float shaping [M])
{
        static int flcoeff[RESOL][Ll]=
        {
          {14520    ,32767    ,14513    ,-19},
          {14108    ,32757    ,14932    ,50},
          {13697    ,32734    ,15354    ,122},
          {13290    ,32697    ,15779    ,198},
          {12886    ,32646    ,16206    ,277},
          {12486    ,32582    ,16636    ,361},
          {12089    ,32504    ,17067    ,449},
          {11697    ,32412    ,17500    ,541},
          {11309    ,32307    ,17934    ,639},
          {10926    ,32189    ,18368    ,741},
          {10547    ,32058    ,18803    ,848},
          {10174    ,31913    ,19238    ,960},
          {9806     ,31756    ,19672    ,1078},
          {9444     ,31586    ,20106    ,1202},
          {9087     ,31403    ,20538    ,1331},
          {8737     ,31208    ,20968    ,1466},
          {8392     ,31001    ,21397    ,1607},
          {8055     ,30781    ,21823    ,1755},
          {7723     ,30550    ,22246    ,1909},
          {7398     ,30308    ,22666    ,2069},
          {7080     ,30054    ,23082    ,2236},
```

```
{6769    ,29789    ,23494    ,2410},
{6465    ,29514    ,23902    ,2590},
{6168    ,29228    ,24305    ,2778},
{5878    ,28931    ,24703    ,2973},
{5596    ,28625    ,25095    ,3174},
{5320    ,28310    ,25481    ,3384},
{5052    ,27985    ,25861    ,3600},
{4792    ,27651    ,26234    ,3823},
{4539    ,27309    ,26600    ,4054},
{4293    ,26958    ,26958    ,4293},
{4054    ,26600    ,27309    ,4539}
{3823    ,26234    ,27651    ,4792},
{3600    ,25861    ,27985    ,5052},
{3384    ,25481    ,28310    ,5320},
{3174    ,25095    ,28625    ,5596},
{2973    ,24703    ,28931    ,5878},
{2778    ,24305    ,29228    ,6168},
{2590    ,23902    ,29514    ,6465},
{2410    ,23494    ,29789    ,6769},
{2236    ,23082    ,30054    ,7080},
{2069    ,22666    ,30308    ,7398},
{1909    ,22246    ,30550    ,7723},
{1755    ,21823    ,30781    ,8055},
{1607    ,21397    ,31001    ,8392},
{1466    ,20968    ,31208    ,8737},
{1331    ,20538    ,31403    ,9087},
{1202    ,20106    ,31586    ,9444},
{1078    ,19672    ,31756    ,9806},
{960     ,19238    ,31913    ,10174},
{848     ,18803    ,32058    ,10547},
{741     ,18368    ,32189    ,10926},
{639     ,17934    ,32307    ,11309},
{541     ,17500    ,32412    ,11697},
{449     ,17067    ,32504    ,12089},
{361     ,16636    ,32582    ,12486},
{277     ,16206    ,32646    ,12886},
```

```
        {198      ,15779    ,32697     ,13290}
        {122      ,15354    ,32734     ,13697}
        {50       ,14932    ,32757     ,14108}
};
```

```
programme  filterl.c  page  2

        long filtout,  /* integer calculation for fast exact results
                        no overflow for a single microphone
                        since sum_over_i(abs(fl coeff[r][i]))<65536 */
float sumout=0;
int m,i,firstel;  /*loop counters, first element for fract. filter*/


/*******************************************************/
/* delay - weighting - sum                           */
for (m=0;m<M;m++)
{
        filtout=0,

        firstel=base-del[m].integer,
                        /* integer delay compensation */

        for (i=0;i<Ll;i++)
                filtout+=flcoeff[del[m].frac][i]*indata [(firstel-
                i+INBUFFER)%INBUFFER][m];

        sumout=sumout+shaping[m]*filtout;


}

/*******************************************************/
/* normalisation and saturation if necessary
(does not occur if sum(abs(shaping))<M    */
sumout=(sumout/M);
sumout=sumout/(11<<16);
if (abs(surnout)>32767)
{
        printf("\nsumout filter 1 exceeds 16 bits: %f ",sumout);
        printf("\nlimited to saturation value ");
        if (sumout>0)
                sumout=32767;
```

```
            else
                    sumout=-32767;
            end
            getchar();
        }
    return( (long) sumout );
    }
```

**programmes calcdelay.c, filter2.c et cons.h**

```
/* calculate integer and fractionnal delay for plane wave      */
/* impinging on a linear array under an angle phi              */
/* can be adapted to other arrays and/or nearfield equations   */
/* Wolfgang Tager, 28.10.96                                    */


#include "cons.h"
#include <math.h>
#include <stdio.h>


struct delay *calcdelay(float phi,int delmax)
{
      extern float xposition[];
      extern float xmax;


      static struct delay del[M];
      int m;
      float tmp;
      for (m=0;m<M;m++)
      {
              tmp=delmax-(xmax-xposition[m])*cos(phi)*Fs/c  +  .5
              /RESOL;
              del[m].integer=(int) tmp;
              del [m].frac=(int) (RESOL*(tmp-del[m].integer));
      }
      return del;
}
/* amplitude egalisation filter */
/* Wolfgang Tager, 28.10.96 */


#include "cons.h"


int filter2(long* outdata)
{
      static int f2coeff[L2]=
```

```
{ -30,66,-189,512,-1246,2760,-5649, 10760,-19311,32767,-19311,
10760,-5639,2760,-1246,512,-189,66,-30};


char shift=17;              /* sum(abs(f2coeff)) < 2^17*/


int i;
float filtout=0;


for (i=0,i<L2;i++)
                filtout+=f2coeff[i]*outdata[i];
return( (int) (filtout/ (Il<<shift) ) );
}


#define       M          10
#define       INBUFFER   1000
#define       RESOL      60
#define       L 1        4
#define       L2         19
#define       Fs         8000
#define       c          340.
struct delay
{
                int integer,
                int frac;
};
```

**Revendications**

1. Dispositif de traitement de signaux numériques véhiculés entre un port commun (C) et M ports particuliers ($P_1$,..., $P_M$) comportant un module de traitement linéaire ($T_1$,...,$T_M$) caractérisé par le fait qu'il comporte des filtres particuliers ($FP_1$,...,$FP_M$) qui assurent à la fois un déphasage et une accentuation d'amplitude choisie à chacun des M ports particuliers ($P_1$,...,$P_M$), ledit déphasage étant spécifique de chaque port particulier ($P_1$,...,$P_M$) et l'accentuation d'amplitude étant sensiblement la même pour tous les ports particuliers ($P_1$,...,$P_M$), et par le fait qu'il comporte au dit port commun (C) un filtre d'inversion (I) commun qui réalise une accentuation d'amplitude inverse de la dite accentuation d'amplitude choisie.

2. Dispositif selon la revendication 1, caractérisé en ce que le port commun (C) est un port de réception d'un signal d'entrée (VE) et en ce que les M ports particuliers ($P_1$,...,$P_M$) sont des ports de transmission de signaux de sortie particuliers ($V_1$,...,$V_M$).

3. Dispositif selon la revendication 1, caractérisé en ce que les M ports particuliers ($P_1$,...,$P_M$) sont des ports de réception de signaux d'entrée ($U_1$,...,$U_M$) particuliers et en ce que le port commun (C) est un port de transmission d'un signal de sortie (US).

**4.** Dispositif selon l'une des revendications 1 à 3, caractérisé en ce que chacun des M filtres particuliers ($FP_1$,...,$FP_M$) a une fonction de transfert fréquentielle qui approche une fonction dont la phase est $2\pi fr$ et où f est la fréquence et où r est un retard comportant une partie fractionnaire, spécifique à chacun des ports particuliers ($P_1$,...,$P_M$).

**5.** Dispositif selon l'une quelconque des revendications 1 à 4, caractérisé en ce que chacun des M filtres particuliers ($FP_1$,...,$FP_M$) a une fonction de transfert fréquentielle dont le module approche une fonction d'accentuation d'amplitude qui est une fonction lisse ayant des valeurs faibles aux alentours de la demi-fréquence d'échantillonnage desdits signaux véhiculés.

**6.** Dispositif selon l'une quelconque des revendications 1 à 4, caractérisé en ce que chacun des M filtres particuliers ($FP_1$,...,$FP_M$) a une fonction de transfert fréquentielle dont le module approche une fonction d'accentuation d'amplitude $|H_{cible}(f)|$ de la forme :

$$|H_{cible}(f)| \; = \; X \; + \; Y \left[ 1 \; + \; \cos \left[ \frac{2\pi f}{f_e} \right] \right]$$

où le rapport X/Y est compris entre 0 et 0,3.

**7.** Dispositif selon la revendication 6, où X est pris égal à 0,06 et Y est pris égal à 0,47.

**8.** Dispositif selon l'une des revendications 1 à 7, caractérisé en ce que le module de traitement linéaire comporte des filtres de traitement linéaire ($T_1$,...,$T_M$) particuliers adjacents aux dits filtres particuliers ($FP_1$,...,$FP_M$).

**9.** Dispositif selon la revendication 3 et l'une des revendications 4 à 8 en combinaison, caractérisé en ce qu'il comporte un dispositif de sommation (S) de signaux en amont du filtre d'inversion commun (I).

**10.** Dispositif selon les revendications 8 et 9 en combinaison, caractérisé en ce que le dispositif de sommation (S) est en aval direct de chacun desdits filtres de traitement linéaire particuliers ($T_1$,...,$T_M$).

**11.** Dispositif selon la revendication 2 et une des revendications 4 à 8 en combinaison, caractérisé en ce qu'il comporte un dispositif de duplication (D) d'un signal en plusieurs signaux qui lui sont identiques en aval du filtre d'inversion commun (I).

**12.** Dispositif d'égalisation selon les revendications 8 et 11 en combinaison, caractérisé en ce que le dispositif de duplication (D) d'un signal en plusieurs signaux qui lui sont identiques est en amont direct de chacun desdits filtres de traitement linéaire particuliers ($T_1$,...,$T_M$).

**13.** Dispositif selon l'une des revendications 1 à 12, caractérisé en ce que le filtre d'inversion (I) commun est un filtre à réponse impulsionnelle finie.

**14.** Dispositif selon l'une des revendications 1 à 12, caractérisé en ce que le filtre d'inversion commun (I) est un filtre à réponse impulsionnelle infinie.

**15.** Dispositif selon l'une des revendications 1 à 14, caractérisé en ce que chacun des filtres particuliers ($FP_1$,...,$FP_M$) a un même nombre de coefficients $L_1$.

**16.** Dispositif selon la revendication 15, caractérisé en ce que pour deux filtres particuliers $h_1$ et $h_2$ dont les retards fractionnaires normalisés respectifs sont symétriques par rapport à un retard égal à la demi-période d'échantillonnage, les coefficients $h_1(n)$ d'un seul de ces deux filtres sont stockés en mémoire, les coefficients $h_2(n)$ de l'autre filtre étant déduits par la relation $h_2(n) = h_1 (L_1 - 1 - n)$, n variant entre 0 et ($L_1$-1).

**17.** Dispositif selon la revendication 9 et l'une quelconque des revendications 10, 13 à 16, en combinaison, caractérisé en ce que des dispositifs de sommation supplémentaires ($S_2$) sont disposés en amont de certains filtres particuliers ($FP_1$), chacun recevant plusieurs signaux d'entrée devant être retardés d'un même retard fractionnaire, de sorte que le dispositif ne présente pas de filtres particuliers ($FP_1$,...,$FP_M$) identiques en double.

**Patentansprüche**

1. Vorrichtung zum Verarbeiten von digitalen Signalen, die zwischen einem gemeinsamen Anschluß (C) und M einzelnen Anschlüssen ($P_1...P_M$), die einen Linearverarbeitungsmodul ($T_1...T_M$) umfassen, übertragen werden, dadurch gekennzeichnet, daß sie einzelne Filter ($FP_1...FP_M$) umfasst, die gleichzeitig für eine Phasenverschiebung und eine gewählte Verstärkung der Amplitude an jedem der einzelnen M Anschlüsse ($P_1...P_M$) sorgen, welche Phasenverschiebung für jeden einzelnen Anschluß ($P_1...P_M$) spezifisch ist und welche Verstärkung der Amplitude für alle einzelnen Anschlüsse ($P_1...P_M$) im wesentlichen die gleiche ist, und daß sie an dem besagten gemeinsamen Anschluß (C) ein gemeinsames Umkehrfilter (I) aufweist, das für eine zu der besagten gewählten Verstärkung der Amplitude umgekehrte Verstärkung der Amplitude sorgt.

2. Vorrichtung nach Anspruch 1, dadurch gekennzeichnet, daß der gemeinsame Anschluß (C) ein Anschluß zum Empfangen eines Eingangssignals (VE) ist und daß die einzelnen M Anschlüsse ($P_1...P_M$) Anschlüsse zum Übertragen von einzelnen Ausgangssignalen ($V_1...V_M$) sind.

3. Vorrichtung nach Anspruch 1, dadurch gekennzeichnet, daß die einzelnen M Anschlüsse ($P_1...P_M$) Anschlüsse zum Empfang von einzelnen Eingangsignalen ($U_1...U_M$) sind und daß der gemeinsame Anschluß (C) ein Anschluß zum Übertragen eines Ausgangssignals (US) ist.

4. Vorrichtung nach einem der Ansprüche 1 bis 3, dadurch gekennzeichnet, daß jedes der einzelnen M Filter ($FP_1...FP_M$) eine frequenzielle Übertragungsfunktion hat, die einer Funktion nahe kommt, bei der die Phase $2\pi f r$ ist, wobei f die Frequenz und r eine einen Bruchteil umfassende Verzögerung ist, die für jeden der einzelnen Anschlüsse ($P_1...P_M$) spezifisch ist.

5. Vorrichtung nach einem der Ansprüche 1 bis 4, dadurch gekennzeichnet, daß jedes der einzelnen M Filter ($FP_1...FP_M$) eine frequenzielle Übertragungsfunktion hat, deren Modul einer Amplitudenverstärkungsfunktion nahe kommmt, die eine Glättungsfunktion mit niedrigen Werten in der Umgebung der Halbfrequenz der Abtastung der besagten übertragenen Signale ist.

6. Vorrichtung nach einem der Ansprüche 1 bis 4, dadurch gekennzeichnet, daß jedes der einzelnen M Filter ($FP_1...FP_M$) eine frequenzielle Übertragungsfunktion hat, deren Modul einer Amplitudenverstärkungsfunktion $|H_{cible}(f)|$ der folgenden Form nahe kommt:

$$|H_{cible}(f)| = X + Y\left[1 + \cos\left[\frac{2\pi f}{f_e}\right]\right]$$

wobei das Verhältnis X/Y zwischen 0 und 0,3 liegt.

7. Vorrichtung nach Anspruch 6, bei der X = 0,06 und Y = 0,47 genommen sind.

8. Vorrichtung nach einem der Ansprüche 1 bis 7, dadurch gekennzeichnet, daß der Linearverarbeitungsmodul einzelne Linearverarbeitungsfilter ($T_1...T_M$) neben den besagten einzelnen Filtern ($FP_1...FP_M$) umfasst.

9. Vorrichtung nach Anspruch 3 und in Kombination einem der Ansprüche 4 bis 8, dadurch gekennzeichnet, daß sie eine Signaladdiereinrichtung (S) umfaßt, die dem gemeinsamen Umkehrfilter (I) vorgeschaltet ist.

10. Vorrichtung kombiniert nach Anspruch 8 und 9, dadurch gekennzeichnet, daß die Addiereinrichtung (S) direkt allen besagten einzelnen Linearverarbeitungsfiltern ($T_1...T_M$) nachgeschaltet ist.

11. Vorrichtung nach Anspruch 2 in Kombination mit einem der Ansprüche 4 bis 8, dadurch gekennzeichnet, daß sie eine Einrichtung (D) zum Verdoppeln eines Signals der vielen Signale, die identisch sind, umfaßt, die dem gemeinsamen Umkehrfilter (I) nachgeschaltet ist.

12. Entzerrungsvorrichtung kombiniert nach den Ansprüchen 8 und 11, dadurch gekennzeichnet, daß die Einrichtung (D) zum Duplizieren eines Signals der vielen Signale, die identisch sind, direkt jedem der besagten einzelnen Linearverarbeitungsfiltern ($T_1...T_M$) vorgeschaltet ist.

**13.** Vorrichtung nach einem der Ansprüche 1 bis 12, dadurch gekennzeichnet, daß das gemeinsame Umkehrfilter (I) ein Filter mit begrenzter Impulsantwort ist.

**14.** Vorrichtung nach einem der Ansprüche 1 bis 12, dadurch gekennzeichnet, daß das gemeinsame Umkehrfilter (I) ein Filter mit unbegrenzter Impulsantwort ist.

**15.** Vorrichtung nach einem der Ansprüche 1 bis 14, dadurch gekennzeichnet, daß jedes einzelne Filter ($FP_1...FP_M$) dieselbe Anzahl von Koeffizienten $L_1$ hat.

**16.** Vorrichtung nach Anspruch 15, dadurch gekennzeichnet, daß für zwei einzelne Filter h1 und h2, deren jeweils normalisierten bruchteilige Verzögerungen bezüglich einer Verzögerung gleich der Halbperiode der Abtastung symmetrisch sind, die Koeffizienten h1(n) eines der beiden Filter in einem Speicher gespeichert sind, während die Koeffizienten h2(n) des anderen Filters durch die Beziehung h2(n) = h1($L_1$-1-n) gegeben sind, wobei n zwischen 0 und ($L_1$-1) variiert.

**17.** Vorrichtung nach Anspruch 9 in Kombination mit einem der Ansprüche 10, 13 bis 16, dadurch gekennzeichnet, daß Zusatzaddiereinrichtungen ($S_2$) vor gegebenen einzelnen Filtern ($FP_1$) angeordnet sind, die jeweils mehrere Eingangssignale empfangen, die vorher um die gleiche bruchteilige Verzögerung verzögert sind, derart, daß die Vorrichtung keine doppelten identischen einzelnen Filter ($FP_1...FP_M$) aufweist.

**Claims**

**1.** A device for processing digital signals conveyed between a common port (C) and M particular ports ($P_1,...,P_M$) including a linear processing module ($T_1,...,T_M$), characterized in that it includes particular filters ($FP_1,...,FP_M$) which simultaneously apply a phase-shift and a chosen amplitude emphasis at each of the M particular ports ($P_1,..., P_M$), said phase-shift being specific to each particular port ($P_1,...,P_M$) and the amplitude emphasis being substantially the same for all the particular ports ($P_1,...,P_M$), and in that it includes at said common port (C) a common inversion filter (I) which performs the inverse amplitude emphasis to said chosen amplitude emphasis.

**2.** Device according to claim 1, characterized in that the common port (C) is a port for receiving an input signal (VE) and in that the M particular ports ($P_1,...,P_M$) are ports for transmitting particular output signals ($V_1,...,V_M$).

**3.** Device according to claim 1, characterized in that the M particular ports ($P_1,...,P_M$) are ports for receiving particular input signals ($U_1,...,U_M$) and in that the common port (C) is a port for transmitting an output signal (US).

**4.** Device according to any one of claims 1 to 3, characterized in that each of the M particular filters ($FP_1, ..., FP_M$) has a frequency domain transfer function which approximates a function whose phase is $2\pi fr$ where f is the frequency and r is a delay having a fractional part specific to each of the particular ports ($P_1,...,P_M$).

**5.** Device according to any one of claims 1 to 4, characterized in that each of the M particular filters ($FP_1,...,FP_M$) has a frequency domain transfer function whose modulus approximates an amplitude emphasis function which is a smoothed function having low values around half the sampling frequency of said signal.

**6.** Device according to any one of claims 1 to 4, characterized in that each of the M particular filters ($FP_1,...,FP_M$) has a frequency domain transfer function whose modulus approximates an amplitude function $|H_{target}(f)|$ of the form:

$$|H_{target}(f)| = X + Y\left[1 + \cos\left[\frac{2\pi f}{f_e}\right]\right]$$

where the ratio X/Y is in the range from 0 to 0.3.

**7.** Device according to claim 6, wherein X is taken as equal to 0.06 and Y is taken as equal to 0.47.

**8.** Device according to any one of claims 1 to 7,
characterized in that the linear processing module includes particular linear processing filters ($T_1,...,T_M$) adjacent said particular filters ($FP_1,...,FP_M$).

**9.** Device according to claim 3 in conjunction with any one of claims 4 to 8, characterized in that it includes a device (S) for summing signals on the input side of the common inversion filter (I).

**10.** Device according to claim 8 in conjunction with claim 9, characterized in that the summing device (S) is directly downstream of each of said particular linear processing filters ($T_1,...,T_M$).

**11.** Device according to claim 2 in conjunction with any one of claims 4 to 8, characterized in that it includes a device (D) for duplicating a signal into a plurality of signals identical to it downstream of the common inversion filter (I).

**12.** Equalization device according to claim 8 in conjunction with claim 11, characterized in that the device (D) for duplicating a signal into a plurality of signals identical to it is directly upstream of each of said particular linear processing filters ($T_1,...,T_M$).

**13.** Device according to any one of claims 1 to 12, characterized in that the common inversion filter (I) is a finite impulse response filter.

**14.** Device according to any one of claims 1 to 12, characterized in that the common inversion filter (I) is an infinite impulse response filter.

**15.** Device according to any one of claims 1 to 14, characterized in that each of the particular filters ($FP_1,...,FP_M$) has the same number of coefficients $L_1$.

**16.** Device according to claim 15, characterized in that, for two particular filters $h_1$ and $h_2$ whose respective normalized fractional delays are symmetrical about a delay equal to half the sampling period, the coefficients $h_1(n)$ of only one of the two filters are stored in memory, the coefficients $h_2(n)$ of the other filter being deduced from the equation $h_2(n) = h_1 (L_1 - 1 - n)$, n varying in the range from 0 to ($L_1-1$).

**17.** Device according to claim 9 in conjunction with any one of claims 10 and 13 to 16, characterized in that additional summing devices ($S_2$) are provided upstream of some particular filters ($FP_1$), each receiving a plurality of input signals to be delayed by the same fractional delay, so that the device has no duplicated identical particular filters ($FP_1,...,FP_M$).

*FIG.1*

EP 0 970 562 B1

*FIG.2*

EP 0 970 562 B1

FIG.3

EP 0 970 562 B1

*FIG. 4*

FIG.5

FIG.6

signal d'entrée 1 mémoire
1 $P_1$
$d_1$

$FP_1$
$h_{T_1}(3)$
$T_1$
Traitement lin.
$h_{T_1}(0)$

$u_M$ signal d'entrée M mémoire
$P_M$
$d_M$

$FP_M$
$h_{T_M}(3)$
$T_M$
Traitement lin.
$h_{T_M}(0)$

S
I
Inversion d'amplitude
C
US

EP 0 970 562 B1

# FIG.7

diifference maximale des gains en dB

# FIG.8

retard de phase (en echantillon)

# FIG.9

phase – phase_ideale (en degre)

# FIG.10

$T_1$

$RF_1$

TT(1) → Retard fractionnaire $r_1$ $\xrightarrow{P_1}$ $V_1$

$T_k$

$RF_k$

TT(k) → Retard fractionnaire $r_k$ $\xrightarrow{P_k}$ $V_k$

VE $\xrightarrow{C}$ D

$T_{M-2}$

$RF_{M-2}$

TT(M-2) → Retard fractionnaire $r_{M-2}$ $\xrightarrow{P_{M-2}}$ $V_{M-2}$

$T_{M-1}$

$RF_{M-1}$

TT(M-1) → Retard fractionnaire $r_{M-1}$ $\xrightarrow{}$ $V_{M-1}$

$R'_{M-1}$

$T_M$

$RF_M$

TT(M) → Retard fractionnaire $r_M$ $\xrightarrow{P_M}$ $V_M$

FIG. 11